# EUROPEAN PATENT APPLICATION

(11) **EP 4 770 319 A1**
(43) Date of publication of application: **01.07.2026**
(21) Application number: 25813249.7
(22) Date of filing: 12.06.2025
(51) Int. Cl.: H10D 30/01, H10D 30/60, H10D 64/01, H10D 64/27

(54) **SHIELDED-GATE TRENCH POWER DEVICE AND PREPARATION METHOD THEREFOR**

(30) Priority: 28.10.2024 CN 202411513760
(71) Applicant: Hangzhou Fullsemi Semiconductor Co., Ltd., Hangzhou, Zhejiang 311418 (CN)
(72) Inventor: LAN, Zongjin, Hangzhou, Zhejiang 311418 (CN); CHEN, Guoshuai, Hangzhou, Zhejiang 311418 (CN); LI, Xiuzhu, Hangzhou, Zhejiang 311418 (CN); LI, Meng, Hangzhou, Zhejiang 311418 (CN)
(74) Representative: Canzler & Bergmeier Patentanwälte Partnerschaft mbB
(86) International application number: PCT/CN2025/100631
(87) International publication number: WO 2026/091544

(57) **Abstract**

A shielded-gate-trench power device and a method for manufacturing the same. The method includes: preparing a semiconductor wafer to be processed; depositing gate polysilicon on the upper surface of the epitaxial layer and the trench structure of the semiconductor wafer, and forming a groove in the gate polysilicon above the trench structure; etching the gate polysilicon under the groove until reaching the oxide layer above the source polysilicon to form two sub-gates, with an inter-gate trench formed between the two sub-gates; performing planarization on the gate polysilicon until the oxide layer on the upper surface of the epitaxial layer is exposed; forming an oxide dielectric layer; the oxide dielectric layer covers the oxide layer above the upper surface of the epitaxial layer and covers the gate polysilicon; and performing planarization on the oxide dielectric layer to obtain a flat surface of the oxide dielectric layer.

## Description

### FIELD OF THE INVENTION

The present disclosure relates to the field of semiconductor technology, and more particularly, to a shielded-gate-trench power device and a method for manufacturing the same.

### BACKGROUND OF THE INVENTION

Shielded-Gate-Trench (SGT) MOSFETs are advanced field-effect transistors that combine the advantages of trench MOSFETs and shielded-gate technology. They have been widely applied in fields such as electric vehicles, renewable energy conversion, and high-efficiency motor drives, demonstrating their importance in modern electronic systems.

Compared with conventional trench MOSFETs, SGT MOSFETs achieve lower on-resistance and reduced switching losses by incorporating shielded-gate structures. To further reduce the switching losses of SGT power devices, the structures of the gate and the shielded gate may be optimized to mitigate the impact of various parasitic capacitances.

In SGT power devices, parasitic capacitances mainly include three components: gate-source capacitance (Cgs), gate-drain capacitance (Cgd), and drain-source capacitance (Cds). These parasitic capacitances directly influence the switching loss, speed, and overall efficiency of the device. Therefore, effectively reducing these parasitic capacitances has become a critical issue in the design of SGT devices.

In the related art, although certain progress has been made in reducing parasitic capacitances in SGT power devices, no effective and flexibly adjustable solution has yet been identified for reducing parasitic capacitances, particularly the gate-source capacitance (Cgs) of SGT devices in accordance with design requirements.

### SUMMARY OF THE INVENTION

The present disclosure provides a shielded-gate-trench power device and a method for manufacturing the same, to solve the problem of high switching power consumption of SGT power devices in the related art, the problem of high parasitic capacitances of SGT power devices in the related art, and the problem of high gate-source capacitance (Cgs) of SGT power devices in the related art.

The method for manufacturing the shielded-gate-trench power device comprises:
preparing a semiconductor wafer to be processed, wherein the semiconductor wafer comprises a substrate layer, an epitaxial layer, and a trench structure, wherein the epitaxial layer is on an upper surface of the substrate layer, the trench structure is in the epitaxial layer, source polysilicon is disposed within the trench structure, and an oxide layer is formed above and around the source polysilicon, and above an upper surface of the epitaxial layer;
depositing gate polysilicon on the upper surface of the epitaxial layer and the trench structure of the semiconductor wafer, and forming a groove in the gate polysilicon above the trench structure;
etching the gate polysilicon under the groove until reaching the oxide layer above the source polysilicon to form two sub-gates, wherein an inter-gate trench is formed between the two sub-gates;
performing planarization on the gate polysilicon until the oxide layer on the upper surface of the epitaxial layer is exposed;
forming an oxide dielectric layer, wherein the oxide dielectric layer covers the oxide layer above the upper surface of the epitaxial layer and covers the gate polysilicon; and
performing planarization on the oxide dielectric layer to obtain a flat surface of the oxide dielectric layer.

In some embodiments, etching the gate polysilicon under the groove until reaching the oxide layer above the source polysilicon to form the two sub-gates further comprises:
etching the gate polysilicon in the groove using a dry anisotropic etching process until reaching the oxide layer above the source polysilicon to form the two sub-gates, and/or
laterally etching the gate polysilicon in the inter-gate trench using an isotropic etching process to adjust a lateral structure of the inter-gate trench.

In some embodiments, a polysilicon etching selection ratio ranges from 50:1 to 100:1, and/or
an isotropic selection ratio is 1:1.

In some embodiments, preparing the semiconductor wafer to be processed further comprises:
providing the substrate layer of the semiconductor wafer and the epitaxial layer on the upper surface of the substrate layer;
etching the trench structure in the epitaxial layer;
forming the oxide layer on edges of the trench structure;
disposing the source polysilicon in a central region of the trench structure; and
forming the oxide layer, wherein the oxide layer is formed above and around the source polysilicon, and above the upper surface of the epitaxial layer.

In some embodiments, in a step of preparing the semiconductor wafer to be processed, the oxide layer is formed by a high-density plasma deposition inter-gate oxide layer forming process or a thermal oxidation growth inter-gate oxide layer forming process.

In some embodiments, after depositing the gate polysilicon on the upper surface of the epitaxial layer and the trench structure of the semiconductor wafer such that the groove is formed above the trench structure, the method further comprises: forming a sacrificial layer above the gate polysilicon; etching the sacrificial layer until the gate polysilicon under the groove is exposed; and
after etching the gate polysilicon under the groove until reaching the oxide layer above the source polysilicon, the method further comprises: removing the sacrificial layer.

In some embodiments, etching the sacrificial layer until the gate polysilicon under the groove is exposed further comprises:
etching the sacrificial layer using a dry anisotropic etching process until the gate polysilicon under the groove is exposed.

In some embodiments, the sacrificial layer is a deposited film formed by chemical vapor deposition, and the sacrificial layer is removed by dry etching or wet etching.

In some embodiments, the sacrificial layer comprises a nitride film and an oxide film;
when the sacrificial layer is a nitride film, the sacrificial layer is subsequently removed by wet etching with hot phosphoric acid;
when the sacrificial layer is an oxide film, the sacrificial layer is subsequently removed by wet etching with hydrofluoric acid.

In some embodiments, after performing planarization on the gate polysilicon until the oxide layer on the upper surface of the epitaxial layer is exposed, the method further comprises:
forming an inter-gate oxide layer on the surface of the gate polysilicon, wherein the inter-gate oxide layer is not higher than the oxide layer on the upper surface of the epitaxial layer.

In some embodiments, a chemical mechanical polishing process is employed for planarization.

In some embodiments, the oxide dielectric layer is formed by a chemical vapor deposition process.

In some embodiments, the oxide dielectric layer is formed by a sub-atmospheric pressure chemical vapor deposition process, and a cavity is formed in a central region of the inter-gate trench.

In some embodiments, after performing planarization on the oxide dielectric layer to obtain the flat surface of the oxide dielectric layer, the method further comprises:
forming dual contact holes at positions of the sub-gates, wherein the dual contact holes are connected to electrodes to lead out the power device to an external circuit.

The present disclosure provides a shielded-gate-trench power device manufactured by the above method for manufacturing a shielded-gate-trench power device.

The shielded-gate-trench (SGT) power device and the method for manufacturing the same provided by the present disclosure, after depositing the gate polysilicon, utilize the groove formed above the trench structure as self-aligned etching windows to perform anisotropic etching on the gate polysilicon to form two sub-gates. An isotropic etching process is adopted to laterally etch the inter-gate trench. According to different design requirements, the isotropic etching amount is selectively adjusted to modify the overlapping areas between the gate and the source as well as between the gate and the shielded gate, thereby enabling adjustable acquisition of an SGT power device with low gate-source capacitance (Cgs).

### BRIEF DESCRIPTION OF DRAWINGS

The above and other features, characteristics, and advantages of the present disclosure will become more apparent from the following description taken in conjunction with the accompanying drawings and embodiments. In the accompanying drawings, identical reference numerals consistently denote identical features, in which:
FIG. 1 shows a flowchart of a method for manufacturing a shielded-gate-trench power device according to an embodiment of the present disclosure.
FIG. 2a shows a schematic cross-sectional view of the device after completion of step S1 in the embodiment shown in FIG. 1;
FIG. 2b shows a schematic cross-sectional view of the device after completion of step S2 in the embodiment shown in FIG. 1;
FIG. 2c shows a schematic cross-sectional view of the device after completion of step S3 in the embodiment shown in FIG. 1;
FIG. 2d shows a schematic cross-sectional view of the device after completion of step S4 in the embodiment shown in FIG. 1;
FIG. 2e shows a schematic cross-sectional view of the device after completion of step S5 in the embodiment shown in FIG. 1;
FIG. 2f shows a schematic cross-sectional view of the device after completion of step S6 in the embodiment shown in FIG. 1;
FIG. 2g shows a schematic cross-sectional view of the device after completion of step S7 in the embodiment shown in FIG. 1;
FIG. 2h shows a schematic cross-sectional view of the device after completion of step S8 in the embodiment shown in FIG. 1;
FIG. 2i shows a schematic cross-sectional view of the device after completion of step S9 in the embodiment shown in FIG. 1;
FIG. 2j shows a schematic cross-sectional view of the device after completion of step S10 in the embodiment shown in FIG. 1;
FIG. 2k shows a schematic cross-sectional view of the device after completion of step S11 in the embodiment shown in FIG. 1; and
FIG. 2l shows a schematic cross-sectional view of the device after completion of step S12 in the embodiment shown in FIG. 1.

### Reference Numerals:

11 Epitaxial Layer;
12 Substrate Layer;
13 Trench Structure;
14 Source Polysilicon;
15 Oxide Layer;
21 Gate Polysilicon;
211 Groove;
212 Sub-Gate;
213 Inter-Gate Trench;
22 Sacrificial Layer;
23 Inter-Gate oxide Layer;
24 Oxide Dielectric Layer;
25 Cavity;
26 Dual Contact Hole;
31 Source Metal Layer.

### DETAILED DESCRIPTION

The present disclosure will be further described in detail below with reference to the accompanying drawings and embodiments. It should be understood that the specific embodiments described herein are only used to explain the present disclosure and are not intended to limit the present disclosure.

In the related art, a shield gate capable of reducing the gate-source capacitance (Cgs) without performing etching has been proposed. Its manufacturing method includes fully oxidizing the exposed shield gate during a wet etching process, and subsequently filling gate polysilicon therein. However, this technical solution is applicable only to a formation process in which the inter-gate oxide layer is grown by thermal oxidation (thermal IPO). In addition, in this technical solution, the width of the polysilicon is limited and cannot be flexibly adjusted, and the inter-gate oxide layer may be excessively thin, leading to an increase in the gate-source leakage current.

An SGT parasitic capacitance can also be divided into an input capacitance Ciss and an output capacitance Coss. The gate-source capacitance (Cgs) is an important part of the input capacitance Ciss (the input capacitance Ciss being equal to the sum of the gate-source capacitance (Cgs) and the gate-drain capacitance (Cgd)), which affects the turn-on speed of the SGT power device.

The gate-source capacitance (Cgs) can be subdivided into four parts, including the capacitance Cgs1 between the gate and the source electrode, the capacitance Cgs2 between the gate and the N+ source region, the capacitance Cgs3 between the gate and the P-type body region, and the capacitance Cgs4 between the gate and the shielded gate (which shares a terminal with the source).

The present disclosure provides a method for manufacturing a shielded-gate-trench (SGT) power device. The method adjusts the physical structure of the device by etching the gate polysilicon to form two separate sub-gates; and an inter-gate trench is formed between the two sub-gates. This structural design effectively reduces the overlapping areas between the gate and the source and between the gate and the shield gate. The reduction in overlapping area directly decreases the gate-source capacitance (Cgs), thereby enabling the fabrication of an SGT power device with low gate-source capacitance (Cgs) while other parasitic capacitances remain unchanged.

The method for manufacturing the shielded-gate-trench power device provided by the present disclosure comprises the following steps:
preparing a semiconductor wafer to be processed, wherein the semiconductor wafer comprises a substrate layer, an epitaxial layer, and a trench structure, wherein the epitaxial layer is on an upper surface of the substrate layer, the trench structure is in the epitaxial layer, source polysilicon is disposed within the trench structure, and an oxide layer is formed above and around the source polysilicon, and above an upper surface of the epitaxial layer;
depositing gate polysilicon on the upper surface of the epitaxial layer and the trench structure of the semiconductor wafer, and forming a groove in the gate polysilicon above the trench structure;
etching the gate polysilicon under the groove until reaching the oxide layer above the source polysilicon to form two sub-gates; an inter-gate trench is formed between the two sub-gates;
performing planarization on the gate polysilicon until the oxide layer on the upper surface of the epitaxial layer is exposed;
forming an oxide dielectric layer, wherein the oxide dielectric layer covers the oxide layer above the upper surface of the epitaxial layer and covers the gate polysilicon; and
performing planarization on the oxide dielectric layer to obtain a flat surface of the oxide dielectric layer.

In the presently disclosed method for manufacturing a shielded-gate-trench power device, after depositing the gate polysilicon, the groove formed above the trench structure is used as a self-aligned etching windows to perform anisotropic etching on the gate polysilicon to form two sub-gates; the inter-gate trench is laterally etched using an isotropic etching process; and the amount of isotropic etching is selectively adjusted according to different design requirements to modify the overlapping areas between the gate and the source and between the gate and the shield gate. In this way, an SGT power device with low gate-source capacitance (Cgs) can be obtained in an adjustable manner.

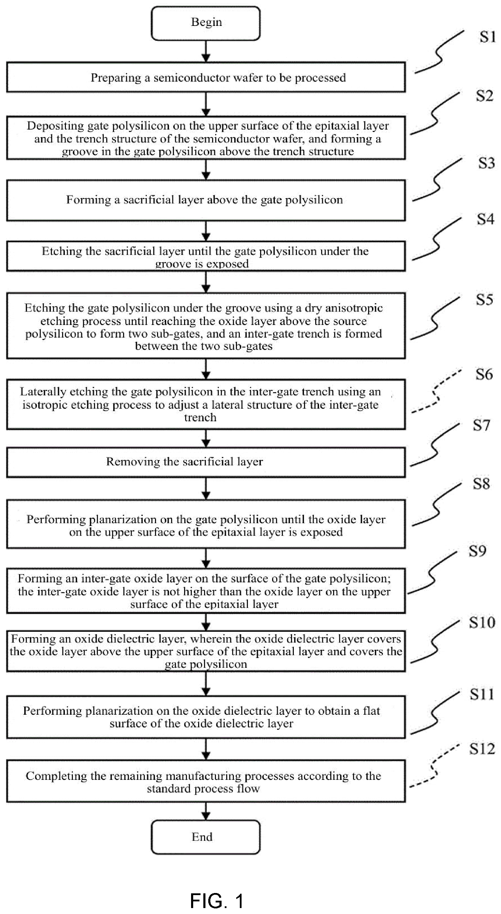

FIG. 1 shows a flowchart of a method for manufacturing a shielded-gate-trench power device according to an embodiment of the present disclosure. As shown in FIG. 1, the method for manufacturing the shielded-gate-trench power device provided by the present disclosure comprises the following steps:
Step S1: preparing a semiconductor wafer to be processed;
Step S2: depositing gate polysilicon on the upper surface of the epitaxial layer and the trench structure of the semiconductor wafer, and forming a groove in the gate polysilicon above the trench structure;
Step S3: forming a sacrificial layer above the gate polysilicon;
Step S4: etching the sacrificial layer until the gate polysilicon under the groove is exposed;
Step S5: etching the gate polysilicon under the groove using a dry anisotropic etching process until reaching the oxide layer above the source polysilicon to form two sub-gates, and an inter-gate trench is formed between the two sub-gates;
Step S6: laterally etching the gate polysilicon in the inter-gate trench using an isotropic etching process to adjust a lateral structure of the inter-gate trench;
Step S7: removing the sacrificial layer;
Step S8: performing planarization on the gate polysilicon until the oxide layer on the upper surface of the epitaxial layer is exposed;
Step S9: forming an inter-gate oxide layer on the surface of the gate polysilicon; the inter-gate oxide layer is not higher than the oxide layer on the upper surface of the epitaxial layer;
Step S10: forming an oxide dielectric layer, wherein the oxide dielectric layer covers the oxide layer above the upper surface of the epitaxial layer and covers the gate polysilicon; and
Step S11: performing planarization on the oxide dielectric layer to obtain a flat surface of the oxide dielectric layer.
Step S6 is an optional preferred step.

Further, after Step S11, the method further comprises:
Step S12: completing the remaining manufacturing processes according to the standard process flow.

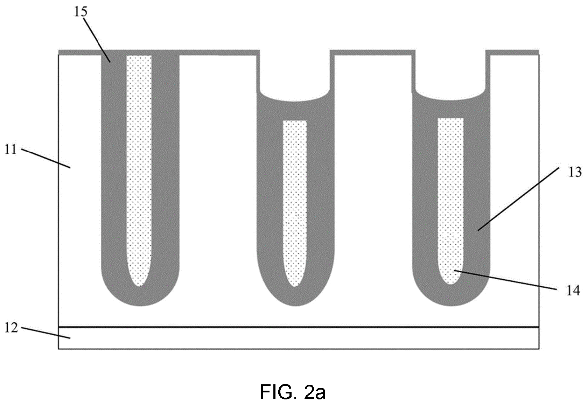

FIGS. 2a to 2l show schematic cross-sectional views of the device after completion of the respective steps in the embodiment shown in FIG. 1. The following describes in detail each step of the method for manufacturing the shielded-gate-trench power device of the present disclosure with reference to FIGs. 2a to 2l.

Step S1: Preparing a semiconductor wafer to be processed.

Please refer to FIG. 2a. The semiconductor wafer to be processed in Step S1 comprises an epitaxial layer 11, a substrate layer 12, and a trench structure 13.

The epitaxial layer 11 is located in an upper region of the device and on the upper surface of the substrate layer 12. The epitaxial layer 11 is typically a high-quality silicon material used to support the current transmission of the device and ensure the electrical characteristics of the channel region; it usually has a low defect density and high electrical conductivity.

The substrate layer 12 is located in a bottommost region of the device and functions to support the entire device. The substrate layer 12 is typically doped silicon, which determines the overall mechanical strength and electrical conductivity of the device. According to the design requirements of the power device, the substrate layer has a high doping concentration to enhance its current-carrying capacity.

The trench structure 13 comprises multiple vertical trenches etched in the epitaxial layer 11. These trenches are prepared for the subsequent filling of gate and shielded gate materials, allowing the gate to be deeply embedded in the substrate, improving the control ability of the electric field, and reducing parasitic capacitances.

In the present disclosure, source polysilicon 14 is disposed within the trench structure 13; an oxide layer 15 is formed above and around the source polysilicon 14, and above the upper surface of the epitaxial layer 11.

By virtue of the above characteristics, the semiconductor wafer to be processed provides a solid foundation to ensure efficient current control and low-loss switching performance can be achieved in subsequent process steps.

More specifically, preparing the above semiconductor wafer to be processed comprises the following steps:
providing the substrate layer 12 of the semiconductor wafer and the epitaxial layer 11 on the upper surface of the substrate layer 12;
etching the trench structure 13 in the epitaxial layer 11;
forming the oxide layer 15 on the edges of the trench structure 13;
disposing the source polysilicon 14 in a central region of the trench structure 13; and
forming the oxide layer 15, wherein the oxide layer 15 is formed above and around the source polysilicon 14, and above the upper surface of the epitaxial layer 11.

In the present disclosure, the oxide layer 15 is formed by a high-density plasma deposition (HDP) inter-gate oxide layer (or inter-poly-oxide, IPO) (HDP IPO) forming process or a thermal oxidation growth inter-gate oxide layer (Thermal IPO) forming process.

HDP IPO is a forming method for depositing an inter-gate oxide layer using high-density plasma, which has high quality and high process flexibility.

Thermal IPO is an inter-gate oxide layer formed by thermal oxidation growth, usually used for the oxide film isolating the SGT gate polysilicon and the source polysilicon.

Step S2: Depositing gate polysilicon on the upper surface of the epitaxial layer and the trench structure of the semiconductor wafer, and forming a groove in the gate polysilicon above the trench structure.

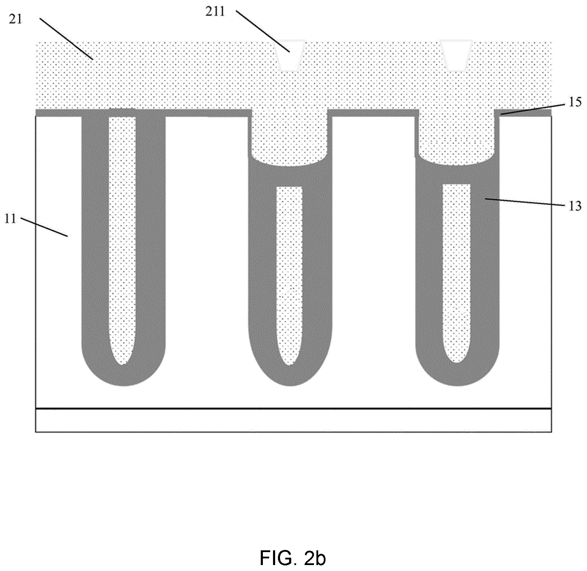

Please refer to FIG. 2b. In Step S2, gate polysilicon 21 is deposited on the upper surface of the epitaxial layer 11 and the trench structure 13 of the semiconductor wafer. During the deposition process, a groove 211 is formed in the gate polysilicon above the trench structure 13. The groove 211 is a structural feature naturally formed during polysilicon deposition.

The gate polysilicon may generally be deposited by chemical vapor deposition (CVD), direct thermal oxidation, a combination of the two (thermal oxidation followed by CVD), or furnace-tube deposition.

Step S3: Forming a sacrificial layer above the gate polysilicon.

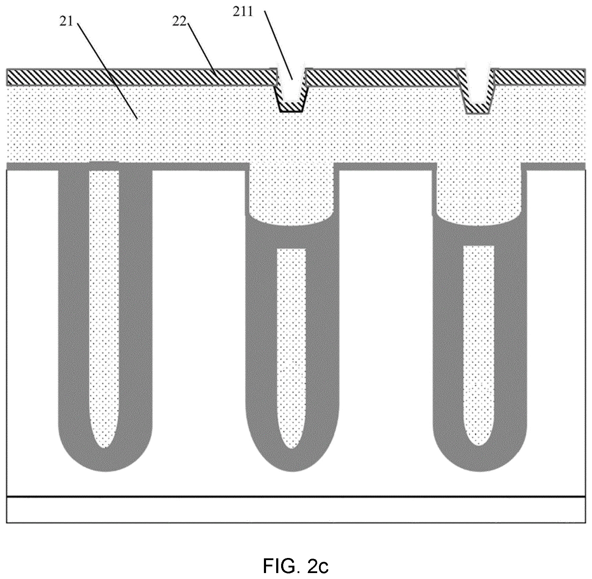

Please refer to FIG. 2c. In Step S3, the sacrificial layer 22 refers to a material layer temporarily provided during the manufacturing process and needs to be removed ultimately; and the sacrificial layer 22 is formed on the gate polysilicon 21.

In the present disclosure, the sacrificial layer 22 is a deposited film formed by a chemical vapor deposition (CVD) process; the deposited film can be a nitride film, an oxide film, or other material layers that can be used as a sacrificial layer to block deposition.

The thickness of the deposited film is related to the structure itself, and the thickness range of the deposited film is usually between 500Å and 2000Å.

By adjusting the thickness of the deposited film, the size of the etching window can be adjusted and controlled. The etching window refers to the opening used for subsequent etching. The parts of the deposited film filled in the groove are relatively thinner, whose thickness is only about 50% to 70% of that at the top.

In Step S3, the thickness of the sacrificial layer 22 at the bottom of the groove is inconsistent with the thickness of the sacrificial layer 22 on the sidewalls of the groove, and the thickness of the sacrificial layer 22 at the top (that is, outside of the groove); the thickness of the sacrificial layer 22 at the bottom of the groove is thinner than that at the top, and the former is approximately 50% to 70% of the latter.

Step S4: Etching the sacrificial layer until the gate polysilicon under the groove is exposed.

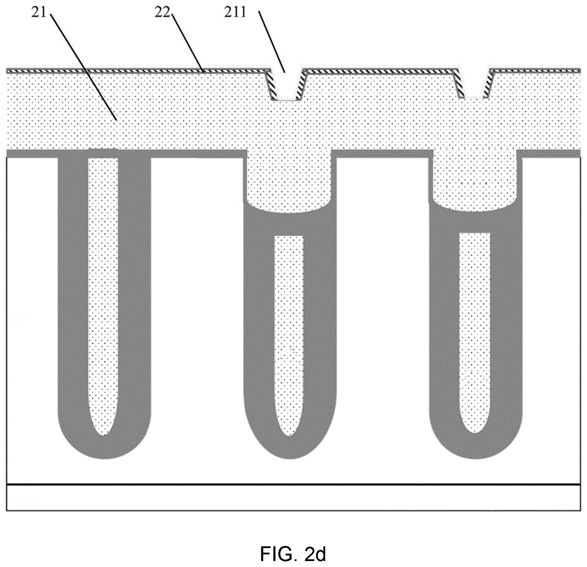

Please refer to FIG. 2d. Using the dry anisotropic etching process, the thinner sacrificial layer 22 at the bottom of the groove 211 can be completely etched away, while a certain thickness of the sacrificial layer 22 on the sidewalls of the groove 211 and at the top (that is, outside of the groove 211) remains, thereby forming a specific self-aligned etching window.

The formation of this etching window is based on the shape and position of the groove itself, without the need to use a photomask for alignment. This naturally occurring mechanism is called "self-alignment". Since no additional photolithography steps are required, production efficiency can be improved and costs can be reduced.

Anisotropic etching refers to an etching process in which the material removal rate differs in different directions. In dry anisotropic etching, by selecting appropriate gases and controlling reaction conditions, preferential etching in specific directions can be achieved, thereby forming a structure with vertical sidewalls.

In the present disclosure, the polysilicon etching selection ratio ranges from 50:1 and 100:1, which means that in this step, the polysilicon is etched at a rate far higher than that of other materials. This can ensure that the etching process has high selectivity, that is, only the target material is effectively etched, and the impact on other materials is very small.

Step S5: Etching the gate polysilicon under the groove using a dry anisotropic etching process until reaching the oxide layer above the source polysilicon to form two sub-gates, and an inter-gate trench is formed between the two sub-gates.

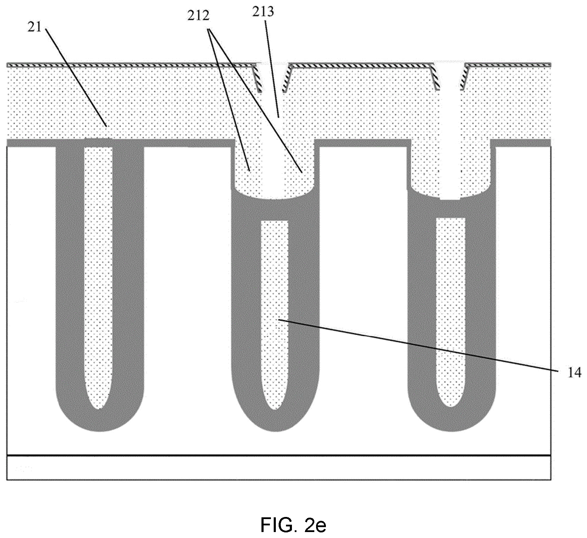

Please refer to FIG. 2e. In Step S5, an anisotropic etching process is used to etch the gate polysilicon 21 in the vertical direction to form two sub-gates 212, and an inter-gate trench 213 of a specific depth is formed between the two sub-gates 212. The present disclosure reduces the overlapping areas between the gate and the shielded gate as well as between the gate and the source through the structure of the two sub-gates and the inter-gate trench between the sub-gates, thereby reducing the gate-source capacitance (Cgs).

In the present disclosure, the polysilicon etching selection ratio ranges from 50:1 and 100:1.

Step S6: Laterally etching the gate polysilicon in the inter-gate trench using an isotropic etching process to adjust a lateral structure of the inter-gate trench.

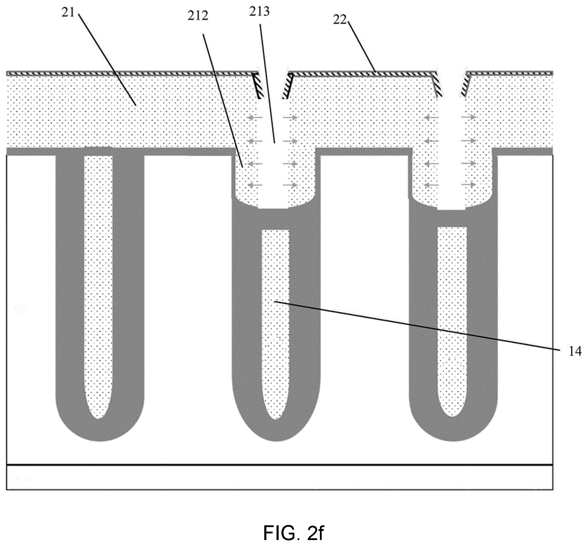

Please refer to FIG. 2f. In Step S6, an isotropic etching process is adopted to laterally etch the gate polysilicon 21 on two sides of the inter-gate trench 213, and the etching amount of lateral etching can be selected according to the structural design requirements, thereby further adjusting the overlapping areas between the gate and the shielded gate as well as between the gate and the source.

This step primarily involves precisely controlling the isotropic etching process to etch the gate polysilicon and to control the geometric structure of the inter-gate trench. By selectively controlling the etching amount of the isotropic etching, the shape of the sub-gates 212 and the width of the inter-gate trench 213 are further adjusted to optimize the overlapping area of the electrodes.

Further, the isotropic selection ratio in Step S6 is 1:1. The polysilicon etching selection ratio ranges from 50:1 and 100:1.

Isotropic etching refers to an etching process in which the etch rate is the same in all directions. This etching method does not distinguish between materials, so the selection ratio is 1:1, meaning that the etching rates of all materials are the same.

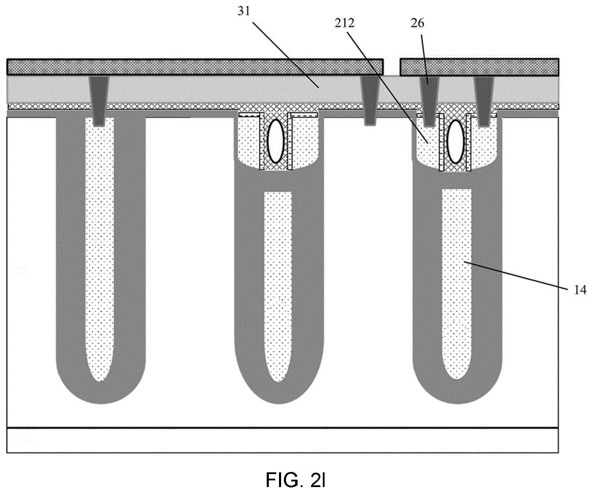

Steps S5 and S6 include operations related to the trench etching process. Based on an analysis of FIGs. 2e, 2f, and 2l, if the etching amount of the inter-gate trench 213 in the horizontal direction increases, the corresponding facing area between the upper gate polysilicon (sub-gates 212) and the lower source polysilicon 214, as well as the subsequent upper source metal plate, will correspondingly decrease, resulting in a reduction in the overlapping area.

As shown in FIG. 2e, in Step S5, the inter-gate trench 213 has been etched, thereby forming a smaller overlapping area. If Step S6 is not performed, the overlapping area formed after Step S5 is fixed and cannot be adjusted further.

In Step S6, as shown in FIG. 2f, the overlapping area between the two sub-gates 212 and the source polysilicon 14 can be further reduced by etching. The shielded gate refers to the source polysilicon 14 under the inter-gate trench 213.

As shown in FIG. 2l, the facing area between the source (the upper source metal layer 31 and the lower source polysilicon 14) and the two sub-gates 212 is greatly reduced.

Therefore, Step S6 is an optional but preferred step because it provides the possibility of further optimizing the overlapping area, thereby having a positive impact on the performance of the final semiconductor device.

Step S7: Removing the sacrificial layer.

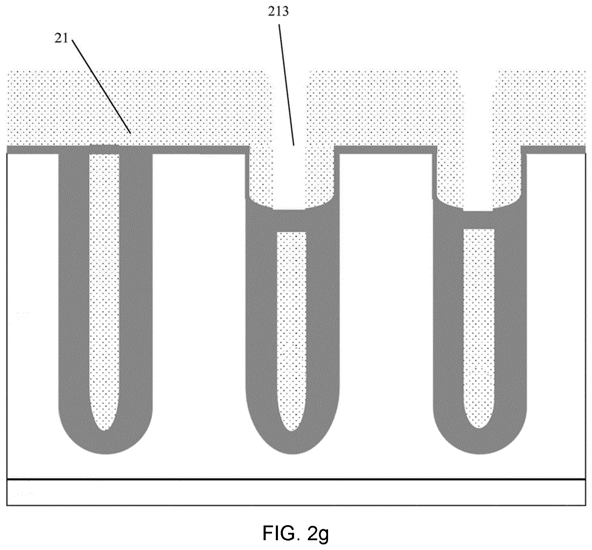

Please refer to FIG. 2g. In Step S7, the sacrificial layer is removed by dry etching or wet etching to expose the gate polysilicon 21. Both dry etching and wet etching are technologies used to remove materials during semiconductor manufacturing.

When the sacrificial layer is a nitride film, the sacrificial layer is subsequently removed by wet etching with hot phosphoric acid;
when the sacrificial layer is an oxide film, the sacrificial layer is subsequently removed by wet etching with hydrofluoric acid.

Step S8: Performing planarization on the gate polysilicon until the oxide layer on the upper surface of the epitaxial layer is exposed.

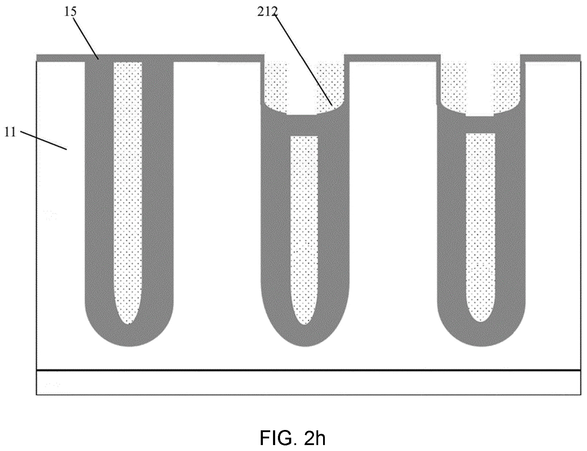

Please refer to FIG. 2h. In Step S8, a chemical mechanical polishing process is employed for planarization.

In this step, surface grinding and etch-back are performed on the gate polysilicon to remove excess polysilicon, ensure the flatness of the gate region, and prepare for subsequent processes.

In the present disclosure, the chemical mechanical polishing process stops on the oxide layer 15 on the upper surface of the epitaxial layer 11. All the gate polysilicon on the upper surface of the epitaxial layer 11 is removed, and the gate polysilicon (two sub-gates 212) in the trench structure 13 is retained.

The etch-back depth generally ranges from 500Å to 1000Å. The etch-back depth refers to the depth achieved during the etching process, which needs to be precisely controlled to meet the requirements of chip design.

The specific etch-back depth is determined according to design requirements, meaning that the polishing depth needs to be precisely controlled according to the actual chip design and manufacturing standards.

Step S9: Forming an inter-gate oxide layer on the surface of the gate polysilicon; the inter-gate oxide layer is not higher than the oxide layer on the upper surface of the epitaxial layer.

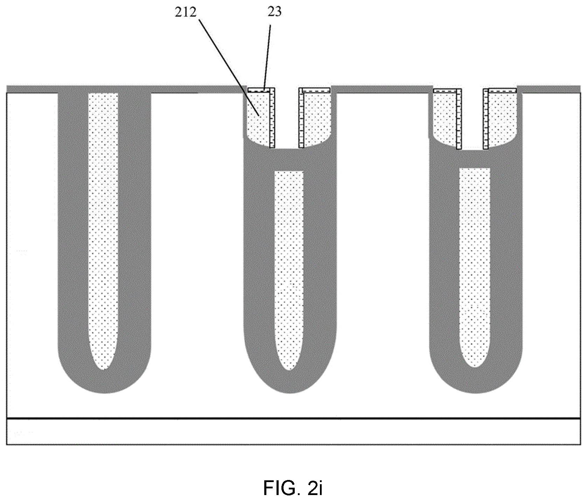

Please refer to FIG. 2i. In Step S9, the gate polysilicon (two sub-gates 212) within the trench structure 13 is oxidized using a high-temperature oxidation process, so that an oxide film protective layer is formed on the surface of the gate polysilicon to ensure electrical isolation in subsequent processes.

In the present disclosure, the oxide film protective layer serves as an inter-gate oxide layer 23, with a thickness ranging from 200Å to 500Å.

Step S10: Forming an oxide dielectric layer, wherein the oxide dielectric layer covers the oxide layer above the upper surface of the epitaxial layer and covers the gate polysilicon.

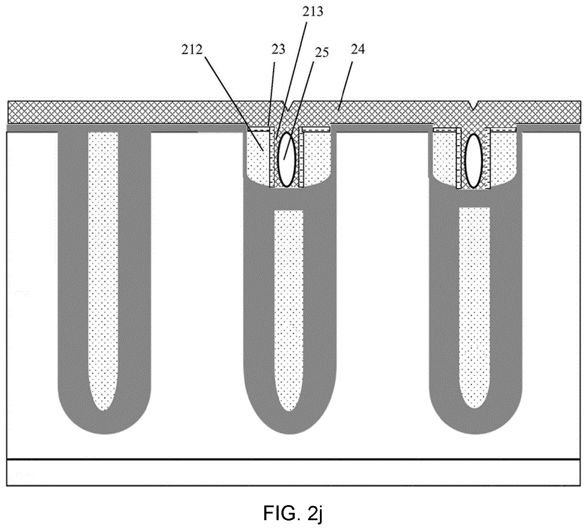

Please refer to FIG. 2j. In Step S10, a sub-atmospheric pressure chemical vapor deposition is adopted to form an oxide dielectric layer 24, such that a cavity 25 is formed in a central region of the inter-gate trench 213;

In the present disclosure, a sub-atmospheric pressure chemical vapor deposition technology is used to cover the entire structural surface with a uniform oxide dielectric layer as a protective layer for the next mechanical polishing. In other embodiments, other chemical vapor deposition processes may also be used to form the oxide dielectric layer 24.

Sub-atmospheric pressure chemical vapor deposition is a chemical vapor deposition technology performed under a low-pressure environment, which can produce a uniform and high-quality oxide film.

Due to the high aspect ratio of this oxide film, that is, the thickness of the film is relatively large compared to its width; an air gap can be formed in the middle of the gate polysilicon, i.e., between the two sub-gates. This airgap structure helps to release and buffer the stress generated within the structure, thereby improving the stability and reliability of the material.

Step S11: Performing planarization on the oxide dielectric layer to obtain a flat surface of the oxide dielectric layer.

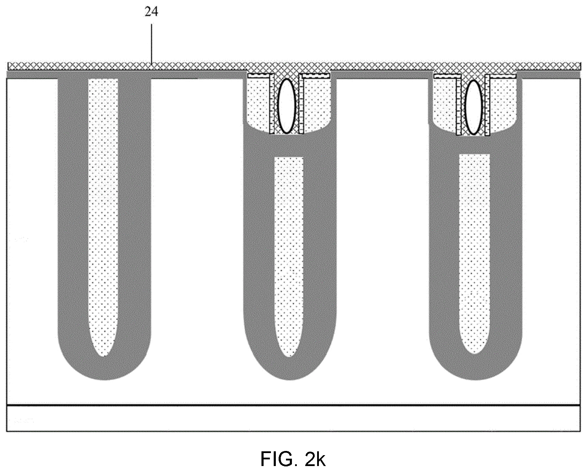

Please refer to FIG. 2k. In Step S11, chemical mechanical polishing is performed on the oxide dielectric layer 24;
the purpose of this step is to planarize the surface of the oxide dielectric layer 24, especially the groove, to facilitate the subsequent formation of contact holes.

By precisely controlling the polishing time, it is possible to ensure that the oxide dielectric layer maintains a certain thickness after polishing, and this remaining thickness range is set between 500Å and 800Å.

Step S12: Completing the remaining manufacturing processes according to the standard process flow.

Please refer to FIG. 2l. In Step S12, the subsequent manufacturing processes are performed according to the normal process flow to complete the integration of the entire SGT power device structure.

Further, dual contact holes 26 are formed in the gate-bus region. The positions of the dual contact holes correspond to the positions of the two sub-gates 212. The dual contact holes 26 are connected to electrodes to connect other external circuits of the power device, ensuring that the device can work normally.

The method for manufacturing the shielded-gate-trench power device provided by the present disclosure adjusts the overlapping areas between the gate and the source electrode as well as between the gate and the shielded gate through precise anisotropic and isotropic etching processes, effectively reducing the gate-source capacitance (Cgs), thereby improving the performance of the device.

Based on the above method for manufacturing the shielded-gate-trench power device, the present disclosure also provides a shielded-gate-trench power device obtained by adopting the manufacturing method.

Since the specific structure of the shielded-gate-trench power device has been described in detail in the manufacturing method, it will not be repeated here.

The shielded-gate-trench power device provided by the present disclosure reduces the overlapping areas between the gate and the source through the shielded-gate-trench design, thereby lowering the gate-source capacitance (Cgs) among the parasitic capacitances. This optimization is critical for improving switching speed and reducing power consumption, because a smaller gate-source capacitance enables faster device switching, resulting in superior performance in high-frequency applications.

In addition, it is worth emphasizing that the shielded-gate-trench power device may include shielded gate trench MOSFETs, demonstrating the broad application potential of this technology.

The shielded-gate-trench power device and the method for manufacturing the same provided by the present disclosure specifically have the following beneficial effects:

The method does not require the use of additional masks and is applicable to two different process routes for medium and high-voltage SGTs with large pitches, namely HDP IPO and thermal IPO;
by adjusting the isotropic etching amount within a certain range, the gate-source overlapping area can be modified, thereby increasing the flexibility in device preparation;
the present disclosure does not affect other parasitic capacitances and maintains the performance of the device; and
a certain cavity is formed in the middle of the device, which helps to buffer and reduce the stress inside the device.

Although the above methods are illustrated and described as a series of actions for simplicity of explanation, it should be understood and appreciated that these methods are not limited by the order of actions, as some actions may occur in different orders and/or concurrently with other actions not illustrated and described herein but understood by those skilled in the art according to one or more embodiments.

As shown in this application and the claims, unless the context clearly indicates otherwise, the words "a", "an", "one", and/or "the" do not specifically refer to the singular and may include the plural. Generally speaking, the terms "comprising" and "including" only indicate that the identified steps and elements are included, and these steps and elements do not constitute an exclusive list, and the method or device may also include other steps or elements.

The above embodiments are provided for those skilled in the art to implement or use the present disclosure. Those skilled in the art can make various modifications or changes to the above embodiments without departing from the inventive concept of the present disclosure. Therefore, the protection scope of the present disclosure is not limited by the above embodiments, but should be the maximum scope consistent with the innovative features mentioned in the claims.

## Claims

1. A method for manufacturing a shielded-gate-trench power device, comprising:
preparing a semiconductor wafer to be processed, wherein the semiconductor wafer comprises a substrate layer, an epitaxial layer, and a trench structure, wherein the epitaxial layer is on an upper surface of the substrate layer, the trench structure is in the epitaxial layer, source polysilicon is disposed within the trench structure, and an oxide layer is formed above and around the source polysilicon, and above an upper surface of the epitaxial layer;
depositing gate polysilicon on the upper surface of the epitaxial layer and the trench structure of the semiconductor wafer, and forming a groove in the gate polysilicon above the trench structure;
etching the gate polysilicon under the groove until reaching the oxide layer above the source polysilicon to form two sub-gates, wherein an inter-gate trench is formed between the two sub-gates;
performing planarization on the gate polysilicon until the oxide layer on the upper surface of the epitaxial layer is exposed;
forming an oxide dielectric layer, wherein the oxide dielectric layer covers the oxide layer above the upper surface of the epitaxial layer and covers the gate polysilicon; and
performing planarization on the oxide dielectric layer to obtain a flat surface of the oxide dielectric layer.

2. The method according to claim 1, wherein etching the gate polysilicon under the groove until reaching the oxide layer above the source polysilicon to form the two sub-gates further comprises:
etching the gate polysilicon in the groove using a dry anisotropic etching process until reaching the oxide layer above the source polysilicon to form the two sub-gates, and/or
laterally etching the gate polysilicon in the inter-gate trench using an isotropic etching process to adjust a lateral structure of the inter-gate trench.

3. The method according to claim 2, wherein a polysilicon etching selection ratio ranges from 50:1 to 100:1, and/or
an isotropic selection ratio is 1:1.

4. The method according to claim 1, wherein preparing the semiconductor wafer to be processed further comprises:
providing the substrate layer of the semiconductor wafer and the epitaxial layer on the upper surface of the substrate layer;
etching the trench structure in the epitaxial layer;
forming the oxide layer on edges of the trench structure;
disposing the source polysilicon in a central region of the trench structure; and
forming the oxide layer, wherein the oxide layer is formed above and around the source polysilicon, and above the upper surface of the epitaxial layer.

5. The method according to claim 4, wherein in a step of preparing the semiconductor wafer to be processed, the oxide layer is formed by a high-density plasma deposition inter-gate oxide layer forming process or a thermal oxidation growth inter-gate oxide layer forming process.

6. The method according to claim 1, wherein after depositing the gate polysilicon on the upper surface of the epitaxial layer and the trench structure of the semiconductor wafer such that the groove is formed above the trench structure, the method further comprises: forming a sacrificial layer above the gate polysilicon; etching the sacrificial layer until the gate polysilicon under the groove is exposed; and
after etching the gate polysilicon under the groove until reaching the oxide layer above the source polysilicon, the method further comprises: removing the sacrificial layer.

7. The method according to claim 6, wherein etching the sacrificial layer until the gate polysilicon under the groove is exposed further comprises:
etching the sacrificial layer using a dry anisotropic etching process until the gate polysilicon under the groove is exposed.

8. The method according to claim 6, wherein the sacrificial layer is a deposited film formed by a chemical vapor deposition process, and the sacrificial layer is removed by a dry etching process or a wet etching process.

9. The method according to claim 6, wherein the sacrificial layer comprises a nitride film and an oxide film;
wherein when the sacrificial layer is a nitride film, the sacrificial layer is subsequently removed by wet etching with hot phosphoric acid;
wherein when the sacrificial layer is an oxide film, the sacrificial layer is subsequently removed by wet etching with hydrofluoric acid.

10. The method according to claim 1, wherein after performing planarization on the gate polysilicon until the oxide layer on the upper surface of the epitaxial layer is exposed, the method further comprises:
forming an inter-gate oxide layer on the surface of the gate polysilicon, wherein the inter-gate oxide layer is not higher than the oxide layer on the upper surface of the epitaxial layer.

11. The method according to claim 1, wherein a chemical mechanical polishing process is employed for planarization.

12. The method according to claim 1, wherein the oxide dielectric layer is formed by a chemical vapor deposition process.

13. The method according to claim 12, wherein the oxide dielectric layer is formed by a sub-atmospheric pressure chemical vapor deposition process, and a cavity is formed in a central region of the inter-gate trench.

14. The method according to claim 1, wherein after performing planarization on the oxide dielectric layer to obtain the flat surface of the oxide dielectric layer, the method further comprises:
forming dual contact holes at positions of the sub-gates, wherein the dual contact holes are connected to electrodes to lead out the power device to an external circuit.

15. A shielded-gate-trench power device, wherein the power device is manufactured by the method for manufacturing the shielded-gate-trench power device according to any one of claims 1 to 14.
